# EUROPEAN PATENT APPLICATION

(11) **EP 4 647 806 A1**
(43) Date of publication of application: **12.11.2025**
(21) Application number: 24193766.3
(22) Date of filing: 09.08.2024
(51) Int. Cl.: G01S 7/481, G01S 17/10, G01S 17/36, G01S 17/894, G01S 17/931

(54) **LIDAR DEVICE**

(30) Priority: 09.05.2024 KR 20240061448
(71) Applicant: LG INNOTEK CO., LTD., Seoul 07796 (KR)
(72) Inventor: Hojun, Lee, 07796 SEOUL (KR); Seung min, Joo, 07796 SEOUL (KR)
(74) Representative: Plasseraud IP

(57) **Abstract**

The lidar device according to the embodiment may include a case, a light receiving module disposed inside the case, a light emitting module disposed inside the case and spaced apart from the light receiving module in a first direction, a main substrate disposed below the light receiving module and the light emitting module and electrically connected to the light receiving module and the light emitting module and a heatsink disposed between the light receiving module and the main substrate and between the light emitting module and the main substrate.

## Description

### TECHNICAL FIELD

The present invention relates to a LiDAR device.

### BACKGROUND

Autonomous vehicles (AVs) use multiple sensors for situational awareness. Sensors that are part of the self-driving system (SDS) of an autonomous vehicle may include one or more cameras, Light Detection and Ranging (LiDAR) devices, and inertial measurement units (IMUs). Cameras or LiDAR devices are used to capture and analyze the surrounding scene of a driving vehicle. The captured scene is then used to detect objects, including static objects such as fixed structures and dynamic objects such as pedestrians and other vehicles. Data collected from sensors can also be used to detect road markings, lane curvature, traffic lights and signs, etc. Additionally, the 3D point cloud scene implementation obtained from the LiDAR device of the driving car may be combined with one or more images acquired from the camera to secure additional insight into the scene or situation around the driving car.

Additionally, a LiDAR transceiver may include a transmitter that transmits light in the ultraviolet (UV), visible, and infrared spectral regions and one or more photodetectors that convert other electromagnetic radiation into electrical signals. To provide high-fidelity object detection and tracking, optical sensors, such as LiDAR devices, require sufficient space for rigidly mounted optical components, one or more transceiver assemblies, processing and driver circuits, cooling elements, cleaning elements, wiring, and motor assemblies. The LiDAR device may also have LiDAR transceiver components rigidly fixed to each other to withstand automotive-grade vibrations, high-speed rotation of the mechanical LiDAR assembly, and to address balance and weight considerations.

In the case of vehicle LiDAR devices installed in a self-driving car or a vehicle, it may be installed in the interior space of the vehicle or the exterior space of the vehicle, not the interior space used by the user. In these cases, the LiDAR devices can be easily exposed to external dust or moisture. Because LiDAR devices transmit and receive optical signals, problems with reduced accuracy may occur due to dust or moisture. Therefore, the LiDAR devices require a packaging structure for waterproofing and dustproofing while providing sufficient accommodating space in the internal space.

In addition, LiDAR devices are composed of various electronic components such as high-power lasers, optical systems, detectors, and data processing systems, and these components can generate a lot of heat during their operation. When excessive heat is generated, the performance of the LiDAR device deteriorates, reducing sensing sensitivity and causing measurement errors.

### SUMMARY

One of the technical objects of the present invention is to provide a lidar module with improved waterproof and dustproof functions.

In addition, one of the other technical objects of the present invention is to provide a LiDAR device with improved heat dissipation performance.

The problem to be solved in the embodiment is not limited to this, and also includes purposes and effects that may be understood from the means of solving the problem or the embodiment described below.

The lidar device according to the embodiment may include a case including a first case and a second case, a shielding member disposed between a coupling surface of the first case and the second case, a light receiving module disposed inside the first case, a light emitting module disposed inside the first case and spaced apart from the light receiving module in a first direction, a main substrate disposed below the light receiving module and the light emitting module and electrically connected to the light receiving module and the light emitting module and a heatsink disposed between the light receiving module and the main substrate and between the light emitting module and the main substrate, and the shielding member is disposed on a same line or higher than the upper surface of the heatsink.

In addition, the light receiving module includes a first substrate on which an image sensor is placed in upper part, the light emitting module includes a second substrate on which a light source is placed in upper part, and the heatsink may be disposed between the first substrate and the main substrate and between the second substrate and the main substrate.

In addition, the heatsink includes a first surface on which the first substrate and the second substrate face each other, a second surface opposite to the first surface and facing the main substrate, and a third surface and a fourth surface on both sides of the first direction, a fifth surface and a sixth surface on both sides of the second direction orthogonal to the first direction, and a length of the heatsink in the first direction may be longer than a length in the second direction.

In addition, the heatsink includes a first protrusion portion protruding from a first area of the first surface toward the first substrate, a second protrusion portion protruding from a second area of the first surface toward the second substrate and a third protrusion portion protruding from a third area of the second surface toward the main substrate, and an upper surface area of the first protrusion portion may be larger than an upper surface area of the second protrusion portion.

In addition, a thickness of the first protrusion portion may be greater than a thickness of the second protrusion portion.

In addition, the third protrusion portion overlaps the first protrusion portion in the vertical direction and may not overlap the second protrusion portion in the vertical direction.

In addition, the lidar device may further include a first adhesive member disposed between the first substrate and the first area of the heatsink, and a second adhesive member disposed between the second substrate and the second area of the heatsink.

In addition, the lidar device may further include a plurality of first components arranged on a lower surface of the first substrate, and the first components vertically overlap with the first area, and the first adhesive member molds the first components and may be in contact with the lower surface of the first substrate and the heat sink..

In addition, the lidar device may further include a plurality of second components arranged on a lower surface of the second substrate, and the second components do not overlap vertically with the second components, and second adhesive member is in contact with a lower surface of the second substrate and the heatsink.

In addition, the first protrusion portion overlaps the image sensor in a vertical direction, and the second protrusion portion may overlap the light source in a vertical direction.

In addition, the upper surface area of the first protrusion portion is formed in the range of 50% to 70% of a lower surface area of the first substrate, and the upper surface area of the second protrusion portion may be formed in the range of 20% to 30% of a lower surface area of the second substrate.

In addition, the heatsink includes a first recess and a second recess formed in steps on the first surface and spaced apart in the first direction, and a third recess and a fourth recess are formed in steps on the second surface and are spaced apart in the first direction, and the first and third recesses overlap in a vertical direction, and the second and fourth recesses may overlap in a vertical direction.

In addition, the fifth surface includes a first side recess extending in the first direction, and the first side recess may be connected to each of the first to fourth recesses.

In addition, the lidar device may further include a first connection substrate electrically connecting the main substrate and the first substrate and a second connection substrate electrically connecting the main substrate and the second substrate, and the first connection substrate is disposed in the first and third recesses and the first side recess, and the second connection substrate may be disposed in the second and fourth recesses and the first side recess.

In addition, the case includes a coupling groove formed in at least one of the first case or the second case, and the shielding member for dust prevention and waterproofing is placed in the coupling groove.

The lidar device according to an embodiment of the present invention may have improved assembly and improved waterproof and dustproof structure.

The heat dissipation performance of the lidar device according to an embodiment of the present invention may be improved.

The LiDAR device according to an embodiment of the present invention secures internal space and easily radiates heat from the light receiver substrate, light emitter substrate, and main substrate to the outside.

### BRIEF DESCRIPTION OF THE DRAWINGS

FIG. 1 is a perspective view of a vehicle equipped with a LiDAR device according to an embodiment of the invention.
FIG. 2 is a perspective view of a LiDAR device according to an embodiment of the present invention.
FIG. 3 is a bottom view of a LiDAR device according to an embodiment of the present invention.
FIG. 4 is an exploded view of a LiDAR device according to an embodiment of the present invention.
FIG. 5 is a partial enlarged view of FIG. 4.
FIG. 6 is a case perspective view of a LiDAR device according to an embodiment of the present invention.
FIG. 7 is a perspective view of the LiDAR device from a different direction with the case removed.
FIG. 8 is an enlarged view of the portion where the first and second substrates and the main substrate are contacted and connected to the heatsink according to an embodiment of the present invention.
FIG. 9 is a cross-sectional view taken along line 8-8' of FIG. 2.
FIG. 10 is a side view of the first and second connection substrates, main substrate, and heatsink seen from the second direction.
FIG. 11 is a perspective view of a heatsink according to the present invention.
FIG. 12 is a top view of the heatsink.
FIG. 13 is a bottom view of the heatsink.
FIG. 14 is a bottom view of the first substrate and second substrate in contact with the heatsink.
FIG. 15 is a top view of the main substrate in contact with the heatsink.

### DETAILED DESCRIPTION

Hereinafter, an embodiments disclosed in this specification will be described in detail with reference to the attached drawings. The suffixes 'module' and 'part' for components used in the following description are given or used interchangeably in consideration of ease of specification preparation, and do not have distinct meanings or roles in themselves. In addition, the attached drawings are intended to facilitate easy understanding of the embodiments disclosed in this specification, and the technical ideas disclosed in this specification are not limited by the attached drawings. Additionally, when an element such as a layer, region or substrate is referred to as being 'on' another component, this includes either directly on the other element or there may be other intermediate elements in between.

LiDAR systems may be referred to as depth detection systems, laser ranging systems, laser radar systems, LIDAR systems, or laser/light detection and ranging (LADAR) systems. LiDAR systems may be used for a variety of purposes. For example, a LiDAR system may be integrated with a vehicle (e.g., an autonomous or semi-autonomous vehicle) and used to provide range determinations for the vehicle. That is, the vehicle may traverse the environment and use the LiDAR system to determine the relative distances of various objects in the environment to the vehicle. This may be accomplished by emitting light from an emitter device in the LiDAR system into the environment and using a detector device in the LiDAR system to detect light returned from the environment (e.g., after reflecting from an object in the environment). How far an object is from the LiDAR system may be determined based on the time elapsed between the time the light is emitted and the time the returned light is detected (e.g., the "time of flight" of the light). Additionally, one or more emitter devices and one or more detectors accommodated in the rotating portion of the LiDAR system such that light is emitted as the rotating portion of the LiDAR system rotates relative to the fixed portion and the returned light may be detected in various directions around the LiDAR system. Rotation of the rotating portion of the LIDAR system may enable the vehicle to obtain distance information for objects located within the entire 360-degree field of view of the vehicle, rather than just in the direction pointed by the one or more emitter devices and/or one or more detector devices. It may be important for the associated information to be readily available for a number of reasons, for example, to enable the vehicle to determine the direction in which any given light emission and/or any given detected return light is heading and/or originating. Without this information associated with the LIDAR system's rotation, the LIDAR system may produce inaccurate range information that may affect the vehicle's functionality.

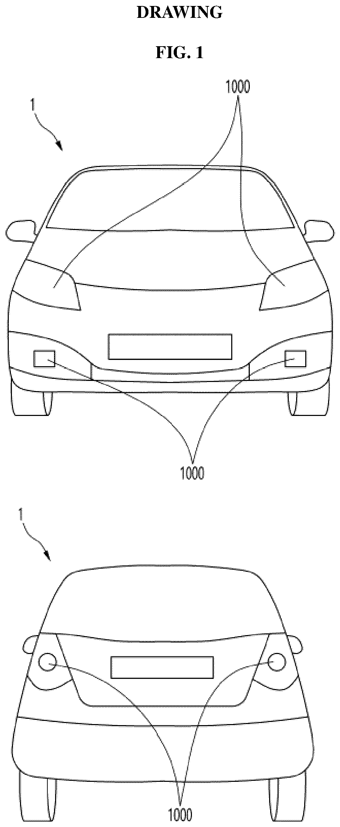

FIG. 1 is a perspective view of a vehicle equipped with a LiDAR device according to an embodiment of the invention.

Referring to FIG. 1, a moving object such as the vehicle 1 may include a LiDAR device 1000. The LiDAR device 1000 may be installed on vehicle lamps, bumpers, etc. Alternatively, unlike FIG. 1, it may be fixed to the top of the vehicle body. However, the location of the LiDAR device 100 described above is only an exemplary embodiment, and is not limited to this, and the LiDAR device may be installed at a location to identify surrounding vehicles.

The LIDAR device 1000 may sense the distance between a vehicle and an object (static object, dynamic object), surrounding environment, and shape, and control driving using the measured data. In addition, a 3D point cloud using this sensing technology may collect and analyze objects and environments surrounding the vehicle, and generate sensing data that provides information about objects located within an appropriate proximity range.

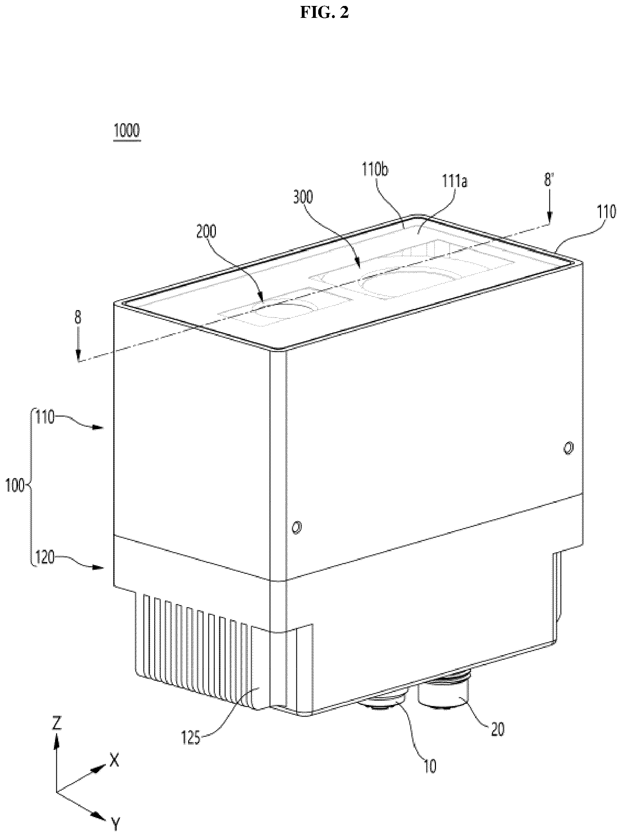

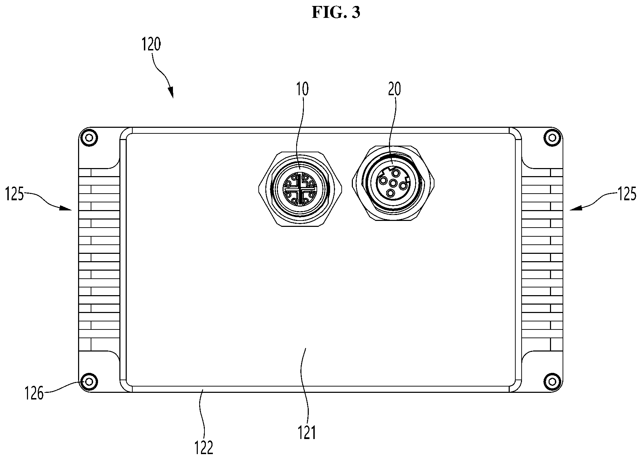

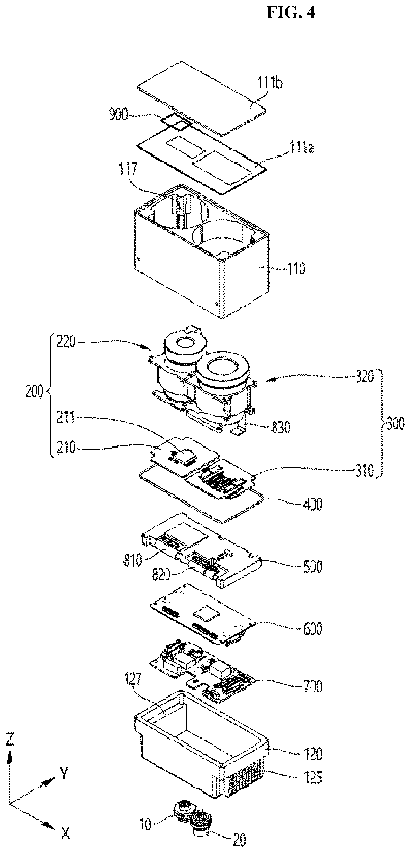

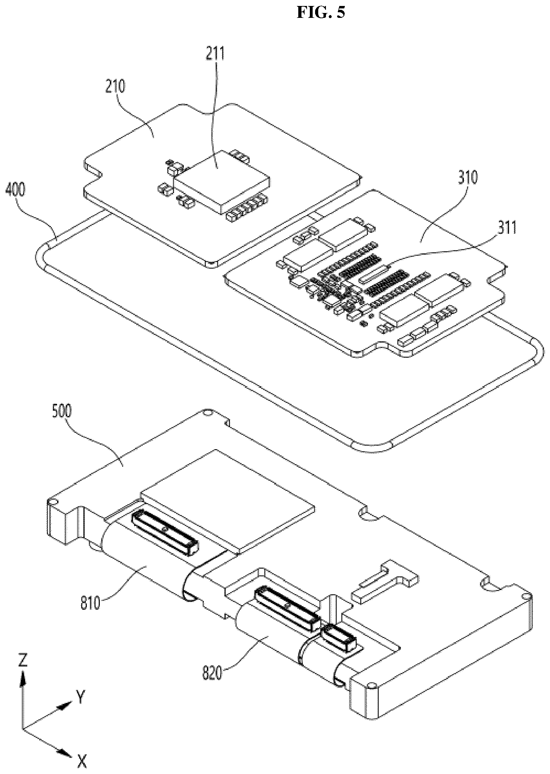

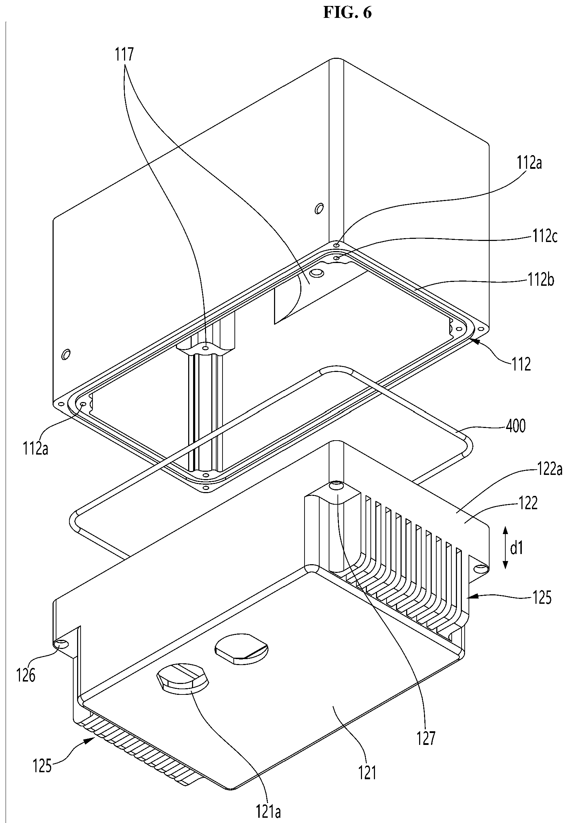

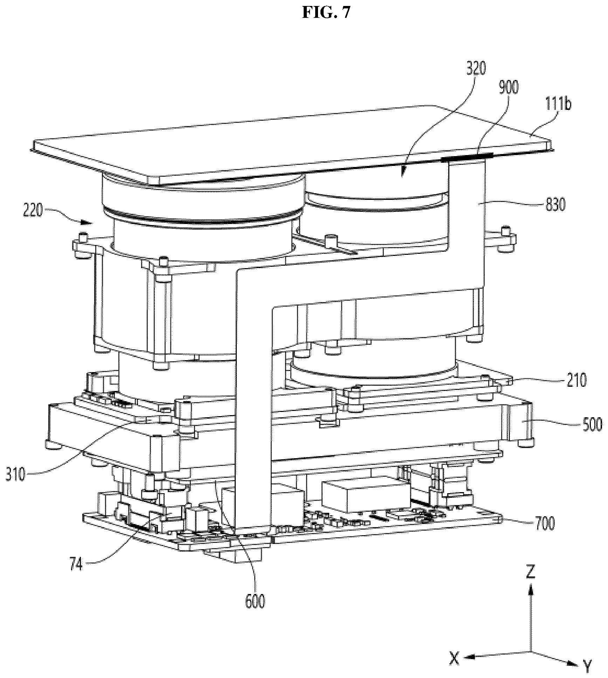

FIG. 2 is a perspective view of a LiDAR device according to an embodiment of the present invention, FIG. 3 is a bottom view of a LiDAR device according to an embodiment of the present invention, FIG. 4 is an exploded view of a LiDAR device according to an embodiment of the present invention, FIG. 5 is a partial enlarged view of FIG. 4, FIG. 6 is a case perspective view of a LiDAR device according to an embodiment of the present invention, FIG. 7 is a perspective view of the LiDAR device from another direction with the case removed.

Referring to FIGS. 2 to 4, the LIDAR device 1000 according to an embodiment of the present invention may include a case 100, a light emitting module 300, a light receiving module 200, a heatsink 500, a main substrate 600, and a power substrate 800.

The case 100 may form the external shape of the LiDAR device 1000. The case 100 may be formed in a rectangular parallelepiped shape to form an internal space that accommodates electronic components for driving the LiDAR device 1000. However, the appearance of case 100 is not limited to this.

The case 100 may include a first case 110 and a second case. The first case 110 may form the upper part of the case 100. The second case 120 may be referred to as an upper case. The second case 120 may form the lower part of the case 100. The second case 120 may be referred to as a lower case.

The first case 110 may be formed so that the top and bottom are open. The first case 110 is an opaque material and may include a metal or non-metal material.

A cover 111a and a glass 111b may be disposed on the upper surface of the first case 110. The cover 111a is made of an opaque material and may form an opening for light to enter and exit the light emitting module 300 and the light receiving module 200.

The glass 111b may be formed of a transparent material. The light emitting module 300 and the light receiving module 200 may emit or receive light into and out of the case 100 through the glass 111b.

A defrost film 900 may be disposed on one side of the glass 111b to prevent frost from forming. The defrost film may generate heat to remove frost formed on the glass 111b.

The light receiving module 200 and the light emitting module 300 may be disposed in the internal space of the first case 110. A coupling portion 117 for coupling the light receiving module 200 and the light emitting module 300 may be formed inside the first case 110.

The heatsink 500, the main substrate 600, and the power substrate 800 may be disposed inside the second case 120. As another example, the heatsink 500 may be placed within the first case.

The power substrate 800 and the main substrate 600 may be sequentially combined inside the second case 120. The second case 120 in which the power substrate 800 and the main substrate 600 are combined may be combined with the first case 110 in which the light receiving module 200, the light emitting module 300, and the heatsink 500 are combined. The first case 110 and the second case 120 are separated to form an internal space, and as each is assembled separately, the assembly rate of the LiDAR device 1000 may be improved.

Referring to FIGS. 2 to 6 and 9, the first case 110 may form a first case lower surface 112 having a thickness. A plurality of first case coupling holes 112a may be formed in the first case lower surface 112 for coupling with the second case 120. For example, the first case coupling hole 112a may be formed at each corner of the first case lower surface 112.

The LIDAR device 1000 may further include a shielding member 400 disposed between the first case 110 and the second case 120.

A coupling groove 112b in which the shielding member 400 is disposed may be formed on the first case lower surface 112. As another example, the shielding member 400 may be placed in a coupling groove formed on the upper surface of the second case. The shielding member 400 may include a rubber material. The shielding member 400 may include a waterproof member. The shielding member 400 may have a ring shape.

The shielding member 400 may shield gaps that may occur when the first case 110 and the second case 120 are combined. The waterproofing and dustproofing efficiency of the lidar device 1000 may be improved by the shielding member 400. The waterproof member may be coupled to the groove of at least one of the first and second cases.

The coupling surface where the first case 110 and the second case 120 are joined may be defined as a virtual horizontal line L. The virtual horizontal line L corresponds to the position where the shielding member 400 is placed. The virtual horizontal line L may be located at the same level or higher than the top surface of the heatsink 500. That is, the shielding member 400 may be located on the same line as the top surface of the heatsink 500 or may be placed at a higher position. Because of this, the heat dissipation member 400 may function to block heat transferred from the second case 120 to the first case 110. In addition, the shielding member 400 expands due to heat transferred to the shielding member 400, thereby reducing the gap in the coupling groove 112b. Because of this, the waterproof and dustproof functions may be further improved.

In addition, since the coupling surface is located higher than the upper surface of the heatsink 500, the contact area between the side of the heatsink 500 and a portion 122a of the side of the second case may be expanded. Because of this, heat from the heatsink 500 may be easily transferred to the second case. A plurality of second case coupling holes 126 may be formed at each corner of the second case 120 to be coupled to the first case.

A heat dissipation fin 125 may be formed on one side of the side 122 of the second case to radiate heat transferred from the heatsink 500 to the outside. For example, the heat dissipation fin 125 may be formed in lower part of the side 122 of the second case.

The heat dissipation fin 125 may be formed to have a concave-convex shape to facilitate dissipation of heat to the outside by expanding the area in contact with external air. A seating portion 127 on which the heatsink 500 may be seated may be formed in the internal space of the second case 122 where the heat dissipation fin 125 is formed. Heat generated from the heatsink 500 may contact the seating portion 127 and be transferred to the heat dissipation fin 125.

A plurality of connection part through-holes 121a for arranging the first connection part 10 and the second connection part 20 may be formed on the lower surface 121 of the second case.

The first case 110 and the second case 120 may be coupled by a fastening member (not shown).

The fastening member (not shown) passes through the second case coupling hole 126 and is coupled to the first case coupling hole 112a, so that the first case 110 and the second case may be fixed.

Referring to FIGS. 2 to 7, the light receiving module 200 may include a first substrate 210 on which an image sensor 211 is disposed and a first optical module 220. The first optical module 220 may include one or more lenses.

The first substrate 210 and the first optical module 220 may be coupled by a fastening member (not shown). A plurality of electronic devices for driving the light receiving module 200 may be disposed on the first substrate 210. The electronic device may include an image sensor 211 and a first component 212.

The first substrate 210 may be a flexible printed circuit board (FPCB), a rigid flexible printed circuit board (RFPCB), or a rigid printed circuit board (RPCB).

The first optical module 220 may be fastened and fixed to the coupling portion 117 of the first case 110.

The first optical module 220 may pass the optical signal reflected from the object. The optical axis of the first optical module 220 may coincide with the optical axis of the image sensor 211. The image sensor 211 may sense light. The image sensor 211 may receive optical signals. The image sensor 211 may detect optical signals and output them as electrical signals. The image sensor 211 may detect light with a wavelength corresponding to the wavelength of light output from the light source. For example, the image sensor 211 may detect light in the infrared band.

The image sensor 211 may be a Complementary Metal Oxide Semiconductor (CMOS) image sensor or a Charge Coupled Device (CCD) image sensor. Additionally, the image sensor 210 may include a ToF sensor that receives IR light reflected from an object and measures the distance using time difference or phase difference.

The light receiving module 200 and the light emitting module 300 may be arranged side by side. The light receiving module 200 may be arranged to be spaced apart from the light emitting module 300 by a certain distance.

The light emitting module 300 may include a second substrate 310 on which the light source 311 is disposed and a second optical module 320. The second optical module 320 may include one or more lenses.

The second substrate 310 and the second optical module 320 may be coupled by a fastening member. A plurality of second components for driving the light emitting module 200 may be disposed on the second substrate 310.

The second substrate 310 may be a flexible printed circuit board (FPCB), a rigid flexible printed circuit board (RFPCB), or a rigid printed circuit board (RPCB).

The second optical module 320 may be fastened and fixed to the coupling portion 117 of the first case 110.

The light emitting module 300 may generate and output an output light signal in the form of a pulse wave or a continuous wave. A continuous wave may be in the form of a sinusoid wave or a squared wave. By generating an output light signal in the form of a pulse wave or continuous wave, the control unit (not shown) of the main substrate 600 may detect time difference or phase difference between the output light signal output from the light emitting module 300 and the input light signal reflected from the object and then input to the light receiving module 200. In this specification, output light refers to light output from the light emitting module 300 and incident on an object, and input light may refer to light output from the light emitting module 300, reflected from an object after reaching the object, and input into the light receiving module 200.

The light source 311 may emit output light. The light generated by the light source may be infrared rays with a wavelength of 770 to 3000 nm. Alternatively, the light generated by the light source may be visible light with a wavelength of 380 to 770 nm. The light source may use a light emitting diode (LED), and may have a plurality of light emitting diodes arranged according to a certain pattern. In addition, the light source may include an organic light emitting diode (OLED) or a laser diode (LD). Alternatively, the light source may be a Vertical Cavity Surface Emitting Laser (VCSEL). VCSEL is one of the laser diodes that converts electrical signals into optical signals, and may output a wavelength of about 800 to 1000 nm, for example, about 850 nm or about 940 nm. If the light source is a VCSEL, the light source may include multiple emitters arranged in an m*n matrix.

The light source repeats blinking (on/off) at regular time intervals to generate an output light signal in the form of a pulse wave or continuous wave. The certain time interval may be the frequency of the output light signal.

The second optical module 320 may converge light output from the light source and output the condensed light to the outside. The second optical module 320 may include at least one lens. When the second optical module 320 includes a plurality of lenses, each lens may be aligned with respect to the central axis to form an optical system. Here, the central axis may be the same as the optical axis of the optical system.

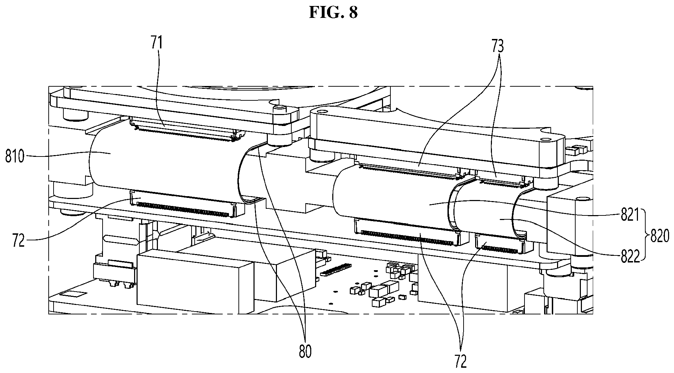

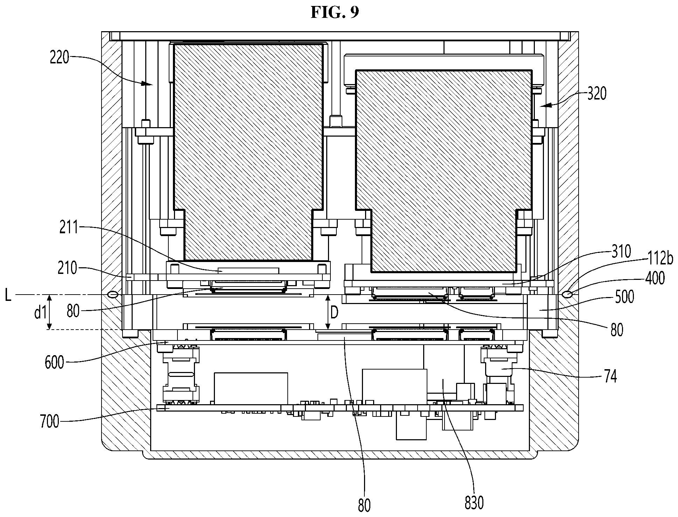

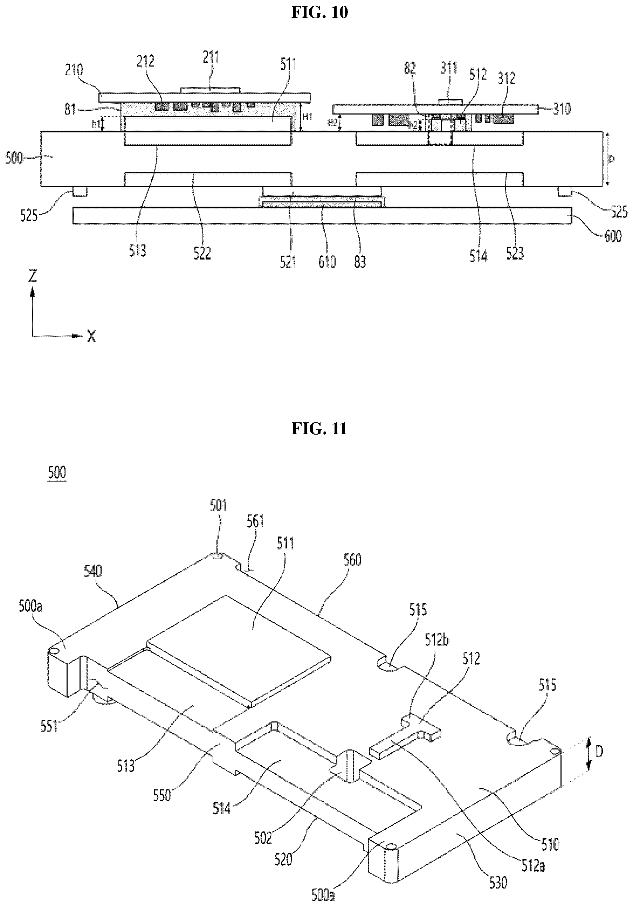

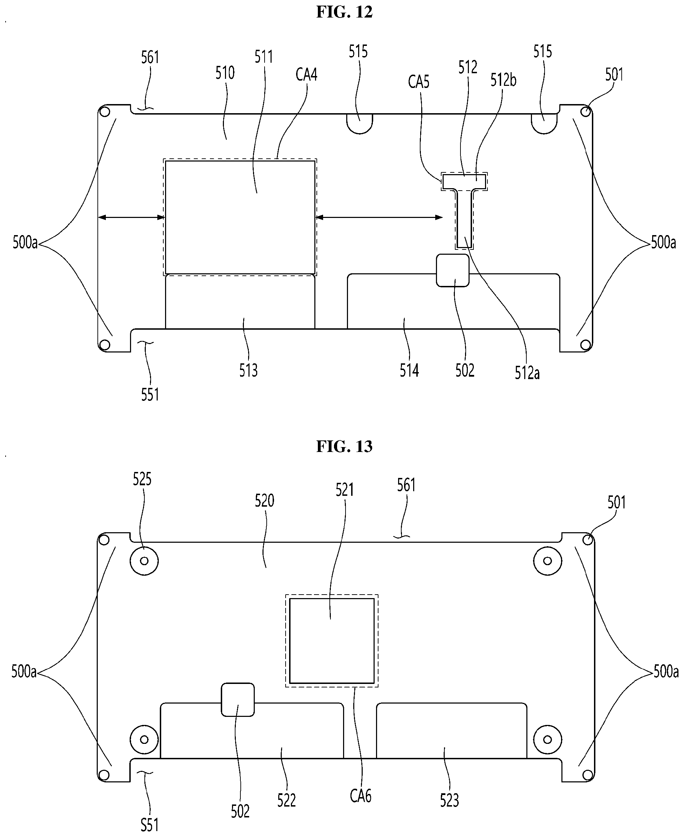

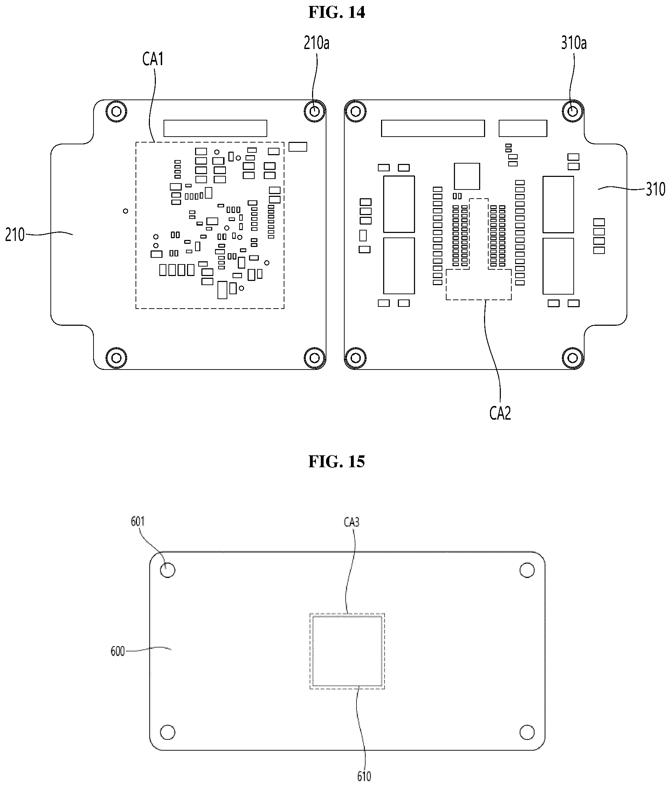

FIG. 8 is an enlarged view of the portion where the first and second substrates and the main substrate are contacted and connected to the heatsink according to the present invention, FIG. 9 is a cross-sectional view taken along line 8-8' of FIG. 2, FIG. 10 is a side view of the first and second connection substrates, the main substrate, and the heatsink seen from the second direction, FIG. 11 is a perspective view of a heatsink according to the present invention, FIG. 12 is a top view of the heatsink, FIG. 13 is a bottom view of the heatsink, FIG. 14 is a bottom view of the first substrate and second substrate in contact with the heatsink, and FIG. 15 is a top view of the main substrate in contact with the heatsink.

Referring to FIGS. 9 to 13, the heatsink 500 may include a first surface 510 where the first substrate 210 and the second substrate 310 face each other, a second surface 520 on the opposite side of the first surface and facing the main substrate, and third and fourth surfaces 530 and 540 on both sides of the first direction, and a fifth and sixth surfaces 550 and 560 on both sides of the second direction orthogonal to the first direction.

The length of the heatsink 500 in the first direction may be longer than the length in the second direction.

The heatsink 500 may include a plurality of case fastening holes 501 for being coupled to the first case 110. A fastening member (not shown) may pass through the case fastening hole 501 and be coupled to the heatsink coupling hole 112c of the first case 110.

The heatsink may include a metal material. For example, the heatsink 500 may include Al or Cu or an alloy having at least one of these.

The thickness D of the heatsink 500 may be 8 mm or more, for example, in the range of 8 to 10 mm. The thickness D of the heatsink may correspond to the thickness d1 of one side of the second case.

In FIGS. 4 and 6, the heatsink 500 is shown to be disposed inside the second case 120 and in contact with the seating portion 127, but the heatsink 500 is not limited to this and may be disposed inside the first case 110 and may contact the seating portion 127.

The third surface 530 and the fourth surface 540 may be surfaces that contact the inner surface of the second case 120. One end of the second surface 520 and the other end of the second surface 520 may be seated on and in contact with the seating portion 127.. Heat may be transferred from the third and fourth surfaces 530 and 540 and a portion of the second surface 520 to the inner surface of the second case 120 and the seating portion 127.

The heatsink 500 may include a first protrusion portion 511 and a second protrusion portion 512 that protrude from the first surface 510. Additionally, the heatsink 500 may include a third protrusion portion 521 protruding from the second surface 520.

The first protrusion portion 511 may protrude from the first surface 510 toward the first substrate 210. That is, the first protrusion portion 511 may protrude in the third direction (z-axis direction). The first protrusion portion 511 may protrude from the fourth area CA4 of the first surface 510, which corresponds to the first area CA1 of the first substrate 210. The first area CA1 and the fourth area CA4 may have corresponding areas and shapes. The first protrusion portion 511 may have a shape corresponding to the shape of the first area CA1. The first protrusion portion 511 may include a polygon, for example, a rectangle.

A first adhesive member 81 may be applied between the first area CA1 and the fourth area CA4. In other words, the first adhesive member 81 may be disposed between the first protrusion portion 511 and the first area CA1 of the first substrate 210. The first area may overlap the image sensor 211 in a vertical direction. The first adhesive member 81 may include a thermally conductive adhesive member.

The first adhesive member 81 may cover a plurality of first components 212 disposed in the first area CA1 in lower part of the first substrate 210. That is, the first protrusion portion 511 may overlap the first component 212 in the vertical direction. The first component 212 disposed on the first substrate 210 has a small size and is tightly arranged, so the first area CA1 may be formed to overlap the first component.

The first adhesive member 81 may be arranged to fill between the lower surface of the first substrate 210 and the lower surface of the first protrusion portion 511. The plurality of first components 212 may be dust-proof, waterproof, and heat-dissipating from the external environment.

The first adhesive member 81 may transfer heat generated in the first component 212 of the first substrate 210 to the heatsink 500 through the first protrusion portion 511.

Heat generated from the first substrate 210, the first component 212, and the image sensor 211 may be easily transferred to the heatsink 500 by the first protrusion portion 511.

The second protrusion portion 512 may be formed to be spaced apart from the first protrusion portion 511 in the first direction. The second protrusion portion 512 may protrude from the first surface 510 toward the second substrate 310. That is, the second protrusion portion 512 may protrude in the third direction (z-axis direction). The second protrusion portion 512 may protrude from the fifth area CA5 corresponding to the second area CA2 of the second substrate 310. The second area CA2 and the fifth area CA5 may correspond to each other in area and shape. The second protrusion portion 512 may have a shape corresponding to the shape of the second area CA2. For example, the second protrusion portion 512 may include a 2-1 protrusion portion 512a extending in the second direction and a 2-2 protrusion portion 512b extending in the first direction. The 2-2 protrusion portion 512b may extend from an end of the 2-1 protrusion portion 512a in the first direction and in a direction (-x) opposite to the first direction.

The second protrusion portion 512 may not vertically overlap the plurality of second components 312 disposed in lower part of the second substrate 310. For example, the height of the upper surface of the second protrusion portion 512 may be higher than the lower surface of at least one of the plurality of second components 312.

A second adhesive member 82 may be applied between the second area CA2 and the fifth area CA5. In other words, the second adhesive member 82 may be disposed between the second protrusion portion 512 and the second area CA2 of the second substrate 310. For example, the second adhesive member 82 may be applied only on the second area CA2 and may not overlap the second component 312 in the vertical direction. As another example, the second adhesive member 82 may vertically overlap and cover some of the plurality of second components 312. Any one of the second components 312 may be disposed in the first through hole 502. The second area CA2 may overlap the light source 311 in a vertical direction. That is, the second protrusion portion 512 may overlap the light source 311 in the vertical direction.

The second adhesive member 82 may transfer heat generated from the second substrate 310 and the second component 312 to the heatsink 500 through the second protrusion portion 512.

The height H1 from the first surface 510 of the heatsink 500 to the lower surface of the first substrate 210 may be greater than the height H2 from the first surface 510 of the heatsink 500 to the lower surface of the second substrate 310. Accordingly, the height h1 of the first protrusion portion 511 may be greater than the height h2 of the second protrusion portion 512. That is, the thickness of the first protrusion portion 511 may be greater than the thickness of the second protrusion portion 512. The height h1 of the first protrusion portion 511 may be 30% to 60% of the height H1 from the first surface 510 to the lower surface of the first substrate 210. This may be a range in which the first component 212 and the first protrusion portion 511 do not contact. The height H2 of the second protrusion portion 512 may be 70% to 90% of the height H2 from the first surface 510 to the lower surface of the second substrate 310.

The upper surface area of the first protrusion portion 511 may be 50% to 70% of the lower surface area of the first substrate 210. The upper surface area of the second protrusion portion 512 may be 20% to 30% of the lower surface area of the second substrate 310. However, it is not limited to this. Because of this, the second protrusion portion 512 can improve heat transfer efficiency from the second substrate 310 to the heatsink 500 while avoiding the second component 312.

The third protrusion portion 521 may protrude to face a portion of the main substrate 600 or an electronic component. The third protrusion portion 521 may protrude from the sixth area CA6 of the second surface 520, which corresponds to the third area CA3 of the main substrate 600. A driver 610 for driving at least one of the image sensor and the light source may be located in the third area CA3 of the main substrate 600. The third area CA3 may be formed to correspond to the shape of the driver 610. The third protrusion portion 521 may be formed to correspond to the third area CA3. That is, the third protrusion portion 521 may be formed to face the driver 610. In other words, the third protrusion portion 521 may overlap the driver 610 in the vertical direction. A third adhesive member 83 may be disposed between the third area CA3 and the sixth area CA6. That is, the third adhesive member 83 may be disposed between the third protrusion portion 521 and the driver 610. The third protrusion portion 521 may be disposed in an area that does not overlap the second protrusion portion 512 in the vertical direction. The third protrusion portion 521 may partially overlap the first protrusion portion 511 in the vertical direction. The third protrusion portion 521 may include a polygonal shape, for example, a rectangular shape. Heat generated from the main substrate 600 and the driver 610 may be easily transferred to the heatsink 500 by the third protrusion portion 521.

The heatsink 500 may include a first recess 513 and a second recess 514 that are concavely formed on the first surface 510.

In detail, the first and second recesses 513 and 514 are arranged to be spaced apart in the first direction on the first surface 510, have a lower depth than the first surface 510, and extend in the second direction. The bottoms of the first and second recesses 513 and 514 may be flat.

The heatsink 500 is spaced apart from the second surface 520 in a first direction and has a stepped depth from the second surface 520, and may include a third recess 522 and a fourth recess 523 extending in the second direction.

The first recess 513 and the third recess 522 may overlap in the vertical direction, and the second recess 514 and the fourth recess 523 may overlap in the vertical direction.

The floor areas of the first recess 513 and the third recess 522 may be the same. The floor areas of the second recess 514 and the fourth recess 523 may be the same. The length of the first recess 513 in the first direction may be equal to the length of the third recess 522 in the first direction. The length of the second recess 514 in the first direction may be equal to the length of the fourth recess 523 in the first direction.

The lengths of the first recess 513 and the second recess 514 in the first direction may be different. The lengths of the first recess 513 and the second recess 514 in the second direction from the fifth surface 550 may be different from each other.

The first recess 513 may be placed adjacent to the first protrusion portion 511, and the second recess 514 may be placed adjacent to the second protrusion portion 512. A portion of the second recess 514 may be formed to overlap the first through hole 502. The distance between the first recess 513 and the first protrusion portion 511 may be smaller than the distance between the second recess 514 and the second protrusion portion 512.

The heatsink 500 may include a first side recess 551 formed on the fifth surface 550. The first side recess 551 may be connected to each of the first to fourth recesses 513, 514, 522, and 523 on the fifth surface 550.

A first connection substrate 810, which will be described later, may be disposed in the first and third recesses 513 and 522 and the first side recess 551.

The heatsink 500 may include a second side recess 561 formed on the sixth surface 560. The second side recess 561 may be formed to allow the third connection substrate 830 to pass through. FIGS. 11 and 12 show that the second side recess 561 is formed to be long in the first direction, but the second side recess 561 may be formed to correspond to the width of the third connection substrate 830.

As the first side recess 551 and the second side recess 561 are formed, a corner portion 500a may be formed. The case fastening hole 501 may be formed in the corner portion 500a. An area in contact with the seating portion 127 of the second case 120 can be further secured by the corner portion 500a. Because of this, more heat may be transferred from the heatsink 500 to the heat dissipation fin 125 of the second case 120.

The second surface 520 may include a plurality of main substrate fastening holes 525 for coupling the main substrate 600. The main substrate fastening hole 525 may be formed at a position corresponding to the heatsink fastening hole 601 of the main substrate 600.

Referring to FIGS. 10 and 13, a first connection substrate 810 connecting the main substrate 600 and the first substrate 210 may be disposed in the first recess 513, third recess 522, and first side recess 551.

The first connection substrate 810 may be a flexible printed circuit board (FPCB). One end of the first connection substrate 810 may be placed in the first recess 513, and the other end of the first connection substrate 810 may be placed in the third recess 522.

The first connection substrate 810 may be electrically connected to the first substrate 210 by a first connector 71. Additionally, the first connection substrate 810 may be electrically connected to the main substrate 600 by the second connector.

A thermally conductive adhesive member is further attached between the first connection substrate 810 and the first and third recesses 513 and 522 so that heat generated from the first connection substrate 810 may be transferred to the heatsink 500.

A second connection substrate 820 connecting the main substrate 600 and the second substrate 310 will be placed in the second recess 514, the fourth recess 523, and the second side recess 561. The second connection substrate 820 may include a 2-1 connection substrate 821 and a 2-2 connection substrate 822.

The second connection substrate 820 may be a flexible printed circuit board (FPCB). One end of the second connection substrate 820 may be placed in the second recess 514, and the other end of the second connection substrate 820 may be placed in the fourth recess 523.

The second connection substrate 820 may be electrically connected to the second substrate 310 by third connector 73. Additionally, the second connection substrate 820 may be electrically connected to the main substrate 600 by the second connector 72.

The thermally conductive adhesive member is further attached between the second connection substrate 820 and the second and fourth recesses 514 and 523 so that heat generated from the second connection substrate 820 may be transferred to the heatsink 500.

The main substrate 600 may include a driver 610 for controlling the light receiving module 200 and the light emitting module 300. The driver 610 may be formed in the third area CA3. Heat generated by the driver 610 may be transferred to the heatsink 500 through the third adhesive member 83.

The main substrate 600 may be a flexible printed circuit board (FPCB), a rigid flexible printed circuit board (RFPCB), or a rigid printed circuit board (RPCB). The main substrate 600 may include a plurality of heatsink fastening holes 601. The heatsink 500 and the main substrate 600 may be fixed through the heatsink fastening hole 601.

The power substrate 800 may be coupled to the inner lower part of the second case 120. The power substrate 800 may be electrically connected to the main substrate 600 by a fourth connector 74.

The power substrate 800 may be a flexible printed circuit board (FPCB), a rigid flexible printed circuit board (RFPCB), or a rigid printed circuit board (RPCB).

The power substrate 800 may be connected to the defrost film by the third connection substrate 830. The third connection substrate 830 may pass through the second side recess 561 and be connected to the defrost film 900 disposed on the glass 111b.

The third connection substrate 830 may receive electrical signals from the power substrate 800 and generate heat in the defrost film 900. The defrost film may remove frost formed on the glass or prevent frost from forming.

Therefore, depending on the arrangement and connection relationship of the light receiving module 200, light emitting module 300, heatsink 500, main substrate 600, and power substrate 700 according to an embodiment of the present invention, heat within the LiDAR device 1000 may be radiated to the outside of the case 100 through a heat transfer method.

The light receiving module 200 and the light emitting module 300 according to an embodiment of the present invention are placed on one substrate, and one heatsink 500 corresponding thereto has a ' 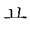 ' shape, and may be placed in contact with the light receiving module 200 and the light emitting module 300. Heat generated from the light receiving module 200 and the light emitting module 300 is emitted toward the bottom of the case 100 through the heatsink 500, the bottom of the case 100 in contact with the heatsink 500, and the heat dissipation fin 125. Or, alternatively, heat may be emitted toward the side of the case 100 through the heatsink 500 and the case 100 in contact with the heatsink 500, thereby performing efficient heat dissipation.

In addition, one heatsink 500 according to an embodiment of the present invention may be placed in contact with the main substrate 600 or the power substrate 700 in a 'T' shape. Heat generated from the main substrate 600 or power substrate 700 is discharged toward the bottom of the case 100 or toward the side of the case 100 through the heatsink 500, thereby performing efficient heat dissipation.

Although the above description focuses on examples, this is only an example and does not limit the examples, and those of ordinary skill in the field to which the embodiment belongs will recognize that various modifications and applications not exemplified above are possible without departing from the essential characteristics of the present embodiment. For example, each component specifically shown in the examples may be modified and implemented. And these variations and differences related to application should be interpreted as being included in the scope of the embodiments set forth in the appended claims.

## Claims

1. A lidar device, comprising:
a case comprising a first case and a second case;
a shielding member disposed between a coupling surface of the first case and the second case;
a light receiving module disposed inside the first case;
a light emitting module disposed inside the first case and spaced apart from the light receiving module in a first direction;
a main substrate disposed below the light receiving module and the light emitting module and electrically connected to the light receiving module and the light emitting module; and
a heatsink disposed between the light receiving module and the main substrate and between the light emitting module and the main substrate,
wherein the shielding member is disposed on a same line or higher than the upper surface of the heatsink.

2. The lidar device according to claim 1, wherein the light receiving module comprises a first substrate on which an image sensor is placed in upper part,
wherein the light emitting module comprises a second substrate on which a light source is placed in upper part, and
wherein the heatsink is disposed between the first substrate and the main substrate and between the second substrate and the main substrate.

3. The lidar device according to claim 2, wherein the heatsink comprises:
a first surface where the first substrate and the second substrate face each other;
a second surface opposite to the first surface and facing the main substrate; and
a third surface and a fourth surface on both sides of the first direction, a fifth surface and a sixth surface on both sides of the second direction orthogonal to the first direction,
wherein a length of the heatsink in the first direction is longer than a length in the second direction.

4. The lidar device according to claim 3, wherein the heatsink comprises:
a first protrusion portion protruding from the first surface toward the first substrate;
a second protrusion portion protruding from the first surface toward the second substrate; and
a third protrusion portion protruding from the second surface toward the main substrate,
wherein an upper surface area of the first protrusion portion is larger than an upper surface area of the second protrusion portion.

5. The lidar device according to claim 4, wherein a thickness of the first protrusion portion is greater than a thickness of the second protrusion portion.

6. The lidar device according to claim 4, wherein the third protrusion portion is configured to overlap the first protrusion portion in the vertical direction and is not configured to overlap the second protrusion portion in the vertical direction.

7. The lidar device according to claim 4, further comprising a first adhesive member disposed between the first substrate and the first protrusion portion, and a second adhesive member disposed between the second substrate and the second protrusion portion.

8. The lidar device according to claim 7, further comprising a plurality of first components arranged on a lower surface of the first substrate,
wherein the first components are configured to vertically overlap with the first protrusion portion, and
wherein the first adhesive member molds the first components and is disposed between the lower surface of the first substrate and the heatsink.

9. The lidar device according to claim 7, further comprising a plurality of second components arranged on a lower surface of the second substrate,
wherein the second components is not configured to overlap vertically with the second protrusion portion,
wherein the second adhesive member is in contact with the lower surface of the second substrate and the heatsink.

10. The lidar device according to claim 4, wherein the first protrusion portion is configured to overlap the image sensor in a vertical direction,
wherein the second protrusion portion is configured to overlap the light source in a vertical direction.

11. The lidar device according to claim 4, wherein the upper surface area of the first protrusion portion is formed in the range of 50% to 70% of a lower surface area of the first substrate,
wherein the upper surface area of the second protrusion portion is formed in the range of 20% to 30% of a lower surface area of the second substrate.

12. The lidar device according to claim 4, wherein the heatsink comprises a first recess and a second recess formed in steps on the first surface and spaced apart in the first direction, and
a third recess and a fourth recess are formed in steps on the second surface and spaced apart in the first direction,
wherein the first and third recesses is configured to overlap in a vertical direction, and the second and fourth recesses is configured to overlap in a vertical direction.

13. The lidar device according to claim 12, wherein the fifth surface comprises a first side recess extending in the first direction, and
wherein the first side recess is connected to each of the first to fourth recesses.

14. The lidar device according to claim 13, further comprising:
a first connection substrate electrically connecting the main substrate and the first substrate; and
a second connection substrate electrically connecting the main substrate and the second substrate,
wherein the first connection substrate is disposed in the first and third recesses and the first side recess,
wherein the second connection substrate is disposed in the second and fourth recesses and the first side recess.

15. The lidar device according to claim 1, wherein the case comprises a coupling groove formed in at least one of the first case or the second case,
wherein the shielding member for dust prevention and waterproofing is placed in the groove.
